# EUROPEAN PATENT APPLICATION

(11) **EP 4 498 781 A1**
(43) Date of publication of application: **29.01.2025**
(21) Application number: 24188816.3
(22) Date of filing: 16.07.2024
(51) Int. Cl.: H10K 59/122, H10K 59/124, H10K 59/131, H10K 59/80, H10K 71/60

(54) **DISPLAY DEVICE AND METHOD FOR MANUFACTURING THE SAME**

(30) Priority: 24.07.2023 KR 20230095807
(71) Applicant: Samsung Display Co., Ltd., Gyeonggi-do 17113 (KR)
(72) Inventor: LI, Xin Xing, Yongin-si (KR); HYUNG, Jun Woo, Yongin-si (KR)
(74) Representative: Marks & Clerk LLP

(57) **Abstract**

A display device includes a substrate, on which a display area and a non-display area are defined, pixels disposed on the substrate, where the pixels include pixel electrodes disposed in emission areas positioned in the display area, light emitting layers disposed on the pixel electrodes, and a common electrode disposed on the light emitting layers, an insulating layer disposed on the substrate and positioned in a non-emission area between the emission areas of the pixels and the non-display area, and a conductive pattern disposed on the insulating layer to be separated from the pixel electrodes of the pixels, where a first voltage is applied to the conductive pattern. The insulating layer includes a lower insulating layer positioned between the pixel electrodes in the display area, and an upper insulating layer disposed on the lower insulating layer and having a greater area than an upper surface of the lower insulating layer.

## Description

### BACKGROUND

### 1. Field

The disclosure relates to a display device and a method for manufacturing the display device.

### 2. Description of the Related Art

The importance of display devices has gradually increased with the development of multimedia. Accordingly, various display devices such as liquid crystal display devices and organic light emitting display devices have been developed.

### SUMMARY

Embodiments of the disclosure provide a display device capable of preventing a leakage current between pixels, and a method for manufacturing the same.

However, embodiments of the disclosure are not restricted to the one set forth herein. The above and other features of embodiments of the disclosure will become more apparent to one of ordinary skill in the art to which the disclosure pertains by referencing the detailed description of embodiments of the disclosure given below.

According to an embodiment of the disclosure, a display device includes a substrate on which a display area and a non-display area are defined, pixels disposed on the substrate, wherein the pixels include pixel electrodes disposed respectively in emission areas positioned in the display area, light emitting layers disposed respectively on the pixel electrodes, and a common electrode disposed on the light emitting layers, an insulating layer disposed on the substrate and positioned in a non-emission area between the emission areas of the pixels and the non-display area, and a conductive pattern disposed on the insulating layer to be separated from the pixel electrodes of the pixels, wherein a first voltage is applied to the conductive pattern, wherein the insulating layer includes a lower insulating layer positioned between the pixel electrodes in the display area, and an upper insulating layer disposed on the lower insulating layer and having a greater area than an upper surface of the lower insulating layer.

In an embodiment, the conductive pattern may include a same conductive material as the pixel electrodes.

In an embodiment, the first voltage may be a turn-off voltage of a light emitting element including the pixel electrode, the light emitting layer, and the common electrode.

In an embodiment, the display device may further include a first electrode positioned in the non-display area, disposed between the substrate and the insulating layer, and connected to the conductive pattern through a contact hole defined through the insulating layer.

In an embodiment, the display device may further include a second electrode positioned in the non-emission area, disposed between the substrate and the insulating layer, and connected to the conductive pattern through a contact hole defined through the insulating layer.

In an embodiment, the upper insulating layer may completely cover the upper surface of the lower insulating layer and protrude toward an adjacent one of the pixels more than the lower insulating layer does.

In an embodiment, the lower insulating layer may include an organic insulating material, and the upper insulating layer may include an inorganic insulating material.

In an embodiment, a thickness of the lower insulating layer may be greater than a thickness of the pixel electrode.

In an embodiment, the thickness of the lower insulating layer may be less than or equal to a sum of thicknesses of the pixel electrode, the light emitting layer, and the common electrode.

In an embodiment, the common electrode of the pixels may be a common film covering the conductive pattern and be entirely disposed in the display area including the emission areas and the non-emission area.

In an embodiment, the thickness of the lower insulating layer may be greater than a sum of thicknesses of the pixel electrode and the light emitting layer.

In an embodiment, the light emitting layers of the pixels may be separated from each other with the lower insulating layer interposed therebetween, and the display device may further include a dummy light emitting layer disposed on the conductive pattern in the non-emission area and separated from the light emitting layers of the pixels.

In an embodiment, the thickness of the lower insulating layer may be less than or equal to a sum of thicknesses of the pixel electrode and the light emitting layer.

In an embodiment, the light emitting layer of the pixels may be a common film covering the conductive pattern and be entirely disposed in the display area including the emission areas and the non-emission area.

In an embodiment, the conductive pattern may have a mesh shape provided with openings corresponding to the emission areas of the pixels when viewed from in a thickness direction of the substrate.

According to an embodiment of the disclosure, a method for manufacturing a display device includes forming transistors and connection electrodes in a display area on a substrate and forming an auxiliary electrode in a non-display area on the substrate, where the display area and the non-display area positioned around the display area are defined on the substrate, and the connection electrodes are connected to the transistors, forming a lower insulating layer by applying an organic insulating material onto the substrate on which the connection electrodes and the auxiliary electrode are formed, and etching the lower insulating layer in a way such that a portion of the auxiliary electrode is exposed, forming an upper insulating layer by applying an inorganic insulating material onto the substrate on which the lower insulating layer is formed, and etching the upper insulating layer in a way such that a portion of the auxiliary electrode in the non-display area is exposed and portions of the lower insulating layer respectively in emission areas positioned in the display area are exposed, etching the lower insulating layer using the upper insulating layer as a mask to pattern the lower insulating layer to be provided with openings corresponding to the portion of the auxiliary electrode and the emission areas, forming respective pixel electrodes in the emission areas and forming a conductive pattern, which is separated from the pixel electrodes, on the exposed portion of the auxiliary electrode and the upper insulating layer, by applying a conductive material onto the substrate on which the patterned lower insulating layer and the upper insulating layer are formed, forming a light emitting layer on the substrate on which the pixel electrodes and the conductive pattern are formed, and forming a common electrode on the substrate on which the light emitting layer is formed.

In an embodiment, in the etching of the lower insulating layer using the upper insulating layer as the mask, the lower insulating layer may be etched in a way such that an upper surface thereof has a smaller area than a lower surface of the upper insulating layer.

In an embodiment, in the forming of the respective pixel electrodes and the forming of the conductive pattern, the pixel electrodes and the conductive pattern may be separated from each other by entirely applying the conductive material at a height less than a height of the lower insulating layer.

In an embodiment, in the forming of the common electrode, the common electrode may be entirely formed in the display area by applying a conductive material for forming the common electrode at a height greater than or equal to a height of the lower insulating layer.

In an embodiment, the method for manufacturing the display device may further include, before the forming of the lower insulating layer, forming an inorganic insulating layer by applying an inorganic insulating material onto the substrate on which the connection electrodes and the auxiliary electrode are formed and etching the inorganic insulating layer in a way such that portions of the auxiliary electrode and each of the connection electrodes are exposed.

At least some of the above and other features of the invention are set out in the claims.

In a display device and a method for manufacturing the display device according to embodiments, it is possible to form pixel electrodes in respective emission areas to be automatically or naturally separated or disconnected from each other by an insulating layer positioned in a non-emission area between the emission areas of pixels and a non-display area and including a lower insulating layer and an upper insulating layer. In addition, it is possible to form a conductive pattern separated or disconnected from the pixel electrodes on the insulating layer while forming the pixel electrodes, by the insulating layer. Accordingly, it is possible to simplify a manufacturing process of the display device and reduce or minimize a distance between the emission areas of the pixels, if desired.

In addition, in the display device and the method for manufacturing the display device according to embodiments, it is possible to define the emission areas by the insulating layer without providing a separate pixel defining layer on the pixel electrodes. Accordingly, it is possible to simplify a structure and a manufacturing process of the display device and increase a degree of freedom in design of the display device.

In addition, in the display device and the method for manufacturing the display device according to embodiments, it is possible to block, prevent, or reduce a leakage current between the pixels by the insulating layer. In addition, it is possible to more effectively block, prevent, or reduce the leakage current between the pixels by applying a first voltage to the conductive pattern on the insulating layer. The conductive pattern may be formed simultaneously with the pixel electrodes, and may effectively block, prevent, or reduce the leakage current without adding a process of forming a separate electrode or line for blocking the leakage current. Accordingly, it is possible to simplify the structure and the manufacturing process of the display device.

However, effects according to the embodiments of the disclosure are not limited to those exemplified above and various other effects are incorporated herein.

### BRIEF DESCRIPTION OF THE DRAWINGS

The above and other features of embodiments of the disclosure will become more apparent by describing in detail embodiments thereof with reference to the attached drawings, in which:
FIG. 1 is a plan view illustrating a display device according to an embodiment;
FIG. 2 is a plan view illustrating a display device according to an embodiment;
FIG. 3 is a schematic circuit diagram illustrating a pixel according to an embodiment;
FIG. 4 is a schematic plan view illustrating a portion of the display device corresponding to area A1 of FIG. 1;
FIG. 5 is a cross-sectional view illustrating the display device according to an embodiment;
FIG. 6 is a cross-sectional view illustrating the display device according to an embodiment;
FIG. 7 is a cross-sectional view illustrating the display device according to an embodiment;
FIG. 8 is a schematic plan view illustrating a portion of the display device corresponding to area A1 of FIG. 1;
FIG. 9 is a cross-sectional view illustrating the display device according to an embodiment;
FIG. 10 is a cross-sectional view illustrating the display device according to an embodiment; and
FIGS. 11 to 19 are cross-sectional views illustrating a method for manufacturing the display device according to an embodiment.

### DETAILED DESCRIPTION

The invention will now be described more fully hereinafter with reference to the accompanying drawings, in which various embodiments of the invention are shown. This invention may, however, be embodied in different forms and should not be construed as limited to the embodiments set forth herein. Rather, these embodiments are provided so that this disclosure will be thorough and complete, and will fully convey the scope of the invention to those skilled in the art.

It will also be understood that when an element or a layer is referred to as being "on" another element or layer, it can be directly on the other element or layer, or intervening layers may also be present therebetween. In contrast, when an element is referred to as being "directly on" another element, there are no intervening elements present. The same reference numbers indicate the same components throughout the specification.

It will be understood that, although the terms "first," "second," etc. may be used herein to describe various elements, these elements should not be limited by these terms. These terms are only used to distinguish one element from another element. For instance, a first element discussed below could be termed a second element without departing from the teachings of the invention. Similarly, the second element could also be termed the first element.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. Thus, reference to "an" element in a claim followed by reference to "the" element is inclusive of one element and a plurality of the elements. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompass both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

Features of each of various embodiments of the disclosure may be partially or entirely combined with each other and may technically variously interwork with each other, and respective embodiments may be implemented independently of each other or may be implemented together in association with each other.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Embodiments are described herein with reference to cross section illustrations that are schematic illustrations of embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

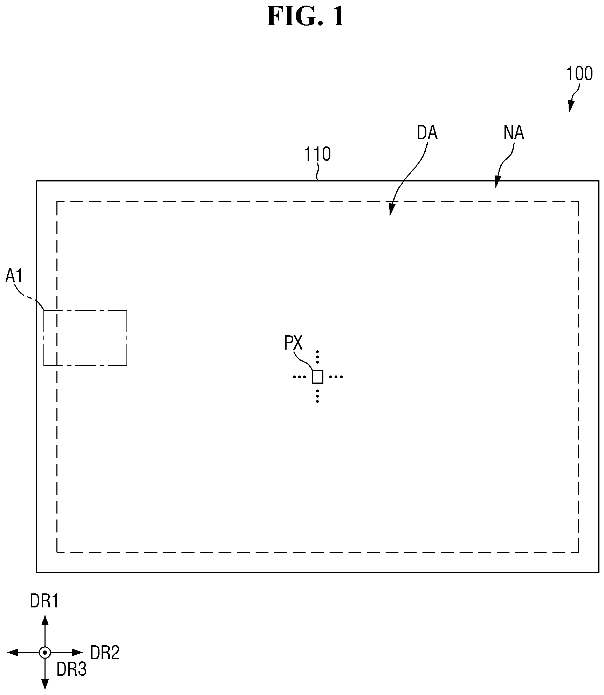

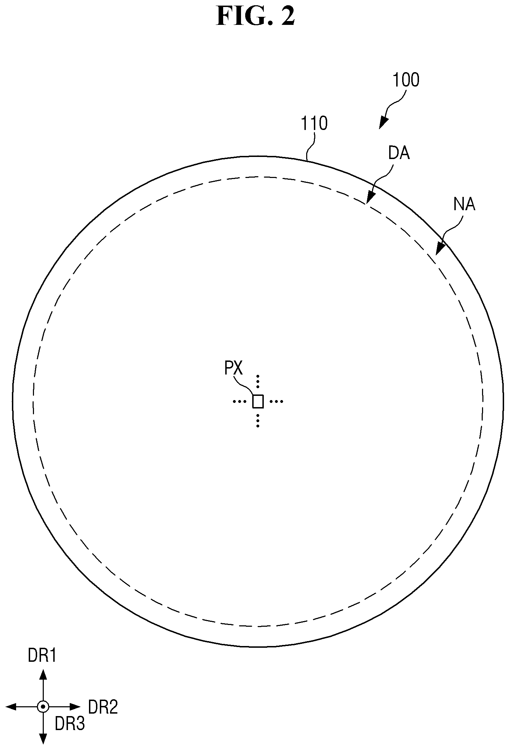

FIG. 1 is a plan view illustrating a display device 100 according to an embodiment. FIG. 2 is a plan view illustrating a display device 100 according to an embodiment. For example, FIGS. 1 and 2 illustrate embodiments of a display device 100 having different shapes from each other.

In FIGS. 1 and 2, a structure of an embodiment of the display device 100 directed to a display panel including a display area DA is briefly illustrated. The display device 100 may include the display panel and driving circuits (e.g., a scan driver, a data driver, and a timing controller) for driving pixels PX. In an embodiment, at least some of the driving circuits may be formed and/or disposed inside the display panel. In another embodiment, the driving circuits may be provided outside the display panel and electrically connected to the display panel.

Referring to FIGS. 1 and 2, an embodiment of the display device 100 may be provided in various shapes, that is, may have a shape which may be variously modified. In an embodiment, the display device 100 may be provided in the form of a panel having a rectangular shape on a plane defined by a first direction DR1 and a second direction DR2 crossing each other, as illustrated in FIG. 1. In an embodiment, as illustrated in FIG. 1, the display device 100 may include angular corners, but the display device 100 may also include rounded corners. The display device 100 may be provided as a panel having a circular shape on the plane defined by the first direction DR1 and the second direction DR2, as illustrated in FIG. 2. In addition, the display device 100 may have one of various other shapes. In an embodiment, for example, the display device 100 may have a non-rectangular polygonal shape, an elliptical shape, or other shapes.

In an embodiment, the display device 100 may be provided as a panel that has a uniform thickness in a third direction DR3 crossing (for example, perpendicular to) the first direction DR1 and the second direction DR2 and is substantially flat. In another embodiment, the display device 100 may be provided as a three-dimensional panel having a curved surface or the like. The display device 100 may be a rigid display device that is not substantially deformed or a flexible display device that may be deformed, for example, folded, bent, or rolled, in at least a portion thereof.

In an embodiment, as illustrated in FIGS. 1 and 2, the display device 100 may have the rectangular shape or the circular shape on the plane defined by the first direction DR1 and the second direction DR2 and is provided to be substantially flat. In such an embodiment, as illustrated in FIGS. 1 and 2, a longitudinal direction (e.g., a column direction or a Y direction) of the display device 100 is indicated as the first direction DR1, a transverse direction (e.g., a row direction or an X direction) of the display device 100 is indicated as the second direction DR2, and a thickness direction (e.g., a height direction or a Z direction) of the display device 100 is indicated as the third direction DR3.

In an embodiment, the display device 100 includes a substrate 110 and pixels PX disposed on the substrate 110. The pixels PX are disposed in a display area DA on the substrate 110.

The substrate 110 is a base member for manufacturing or providing the display device 100, and may constitute a base surface of the display device 100. The substrate 110 may include a display area DA and a non-display area NA (also referred to as a "bezel area") positioned or defined around the display area DA.

The display area DA is an area in which an image is displayed, and may have various shapes. In embodiments, for example, the display area DA may have various shapes including a rectangular shape, a non-rectangular polygonal shape, a circular shape, or an elliptical shape.

In an embodiment, the display area DA may have a shape corresponding to (e.g., substantially similar to) the shape of the display device 100 (or the substrate 110). In an embodiment, for example, the display area DA may have a rectangular shape as in an embodiment of FIG. 1 or a circular shape as in an embodiment of FIG. 2. However, embodiments are not limited thereto, and the display area DA may also have a shape different from that of the display device 100 (or the substrate 110).

The display area DA may include pixel areas in which the pixels PX are provided and/or disposed. In an embodiment, for example, each pixel PX may be disposed in each pixel area positioned in the display area DA.

Each pixel area may include an emission area in which at least one light emitting element is provided or formed and which emits light of a specific color (e.g., red light, green light, or blue light). In an embodiment, for example, each pixel PX may include a light emitting element disposed in each emission area. Each pixel PX may further include a pixel circuit connected to the light emitting element. The pixel area of the pixel PX may include an emission area in which the light emitting element is disposed and a pixel circuit area in which circuit elements of the pixel circuit are disposed. The emission area and the pixel circuit area of each pixel may or may not overlap each other.

The pixels PX may have various shapes. In an embodiment, a shape of each of the pixels PX may be defined based on a shape of the emission area corresponding thereto. In an embodiment, for example, each pixel PX may have a rectangular shape as illustrated in FIGS. 1 and 2, or have a non-rectangular polygonal shape (e.g., a hexagonal shape, an octagonal shape, etc.), a circular shape, an elliptical shape, or other shapes.

The pixels PX may be arranged in the display area DA according to various arrangement structures. In an embodiment, for example, the pixels PX may be arranged in the display area DA in a stripe structure, a delta structure, a PenTile^{™} structure, or other arrangement structures.

The non-display area NA may be an area other than the display area DA. Lines connected to the pixels PX, pads, and/or an embedded circuit unit (e.g., a scan driver formed on the substrate 110 together with the pixels PX) may be disposed in the non-display area NA on the substrate 110. In an embodiment, an integrated circuit chip including at least some (e.g., a data driver) of the driving circuits may be disposed or mounted in the non-display area NA on the substrate 110.

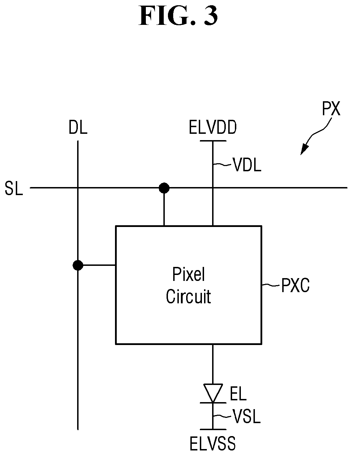

FIG. 3 is a schematic circuit diagram illustrating a pixel PX according to an embodiment.

Referring to FIG. 3 in addition to FIGS. 1 and 2, each pixel PX may include a light emitting element EL connected to a first power line VDL, to which a first source voltage ELVDD is applied, and a second power line VSL, to which a second source voltage ELVSS is applied. Each pixel PX may further include a pixel circuit PXC connected to the light emitting element EL for controlling a driving current supplied to the light emitting element EL.

The pixel circuit PXC may be connected between the first power line VDL and the light emitting element EL. Depending on a structure and/or a type of the pixel circuit PXC, the pixel circuit PXC may also be connected between the light emitting element EL and the second power line VSL.

The pixel circuit PXC may be further connected to at least one scan line SL, to which at least one scan signal is applied, and a data line DL, to which a data signal is applied. Depending on a structure, a type, and/or a driving method of the pixel circuit PXC, the pixel circuit PXC may be further connected to at least one other power line, to which an initialization source voltage, a bias voltage, or the like is supplied, an emission control line, to which an emission control signal is supplied, or the like.

The pixel circuit PXC may control the driving current supplied to the light emitting element EL in response to driving signals supplied to the pixel PX. In an embodiment, for example, the pixel circuit PXC may control a magnitude, a supply timing, and the like, of the driving current supplied to the light emitting element EL in response to driving signals including scan signals, data signals, or the like.

The pixel circuit PXC may include circuit elements for controlling the driving current flowing to the pixel PX in response to the driving signals. In an embodiment, for example, the pixel circuit PXC may include circuit elements including a switching transistor for transferring the data signal supplied to the data line DL into the pixel during a period in which the scan signal of a gate-on voltage is supplied to the scan line SL, a capacitor for storing the data signal, and a driving transistor for generating the driving current corresponding to the data signal. In an embodiment, the pixel circuit PXC may further include at least one other transistor for compensating for a luminance deviation between the pixels PX, or the like.

The light emitting element EL may be connected between the pixel circuit PXC and the second power line VSL. The light emitting element EL may emit light in response to the driving current supplied from the pixel circuit PXC. In an embodiment, for example, the light emitting element EL may emit light with a luminance corresponding to the magnitude of the driving current during a period in which the driving current is supplied from the pixel circuit PXC.

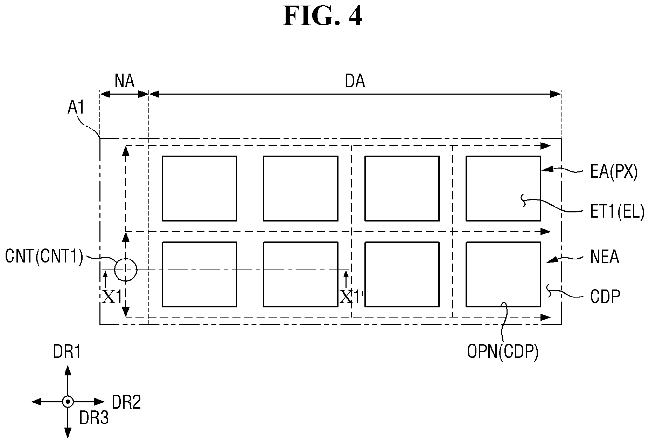

FIG. 4 is a schematic plan view illustrating a portion of the display device 100 corresponding to area A1 of FIG. 1. In an embodiment, as illustrated in FIG. 4, emission areas EA of the pixels PX may have substantially the same shape and/or size, but embodiments are not limited thereto. In an embodiment, for example, the display device 100 may include the pixels PX including emission areas EA having different shapes and/or sizes (e.g., first color pixels, second color pixels, and/or third color pixels including emission areas EA having different shapes and/or sizes). In addition, an embodiment having a structure in which the emission areas EA are arranged in a matrix form along the first direction DR1 and the second direction DR2 has been illustrated in FIG. 4, but an arrangement structure of the emission areas EA may be variously changed or modified depending on embodiments.

Referring to FIG. 4 in addition to FIGS. 1 to 3, in an embodiment, the display area DA includes the emission areas EA of the pixels PX. In addition, the display area DA may further include a non-emission area NEA excluding the emissive areas EA. The non-emission area NEA may be disposed between and/or around the emission areas EA. The non-emission area NEA may surround each emission area EA.

At least one light emitting element EL may be provided or disposed in each emission area EA. In an embodiment, for example, a first electrode ET1 (hereinafter referred to as a "pixel electrode ET1") of the light emitting element EL is disposed in each emission area EA. A light emitting layer and a second electrode (hereinafter referred to as a "common electrode ET2") of the light emitting element EL are sequentially disposed and/or stacked on the pixel electrode ET1.

A conductive pattern CDP may be provided in the non-emission area NEA of the display area DA and the non-display area NA. The conductive pattern CDP may be provided with openings OPN defined therethrough to correspond to the emission areas EA. In an embodiment, for example, a mesh-shaped conductive pattern CDP provided with openings having sizes and/or shapes corresponding to those of the emission areas EA and disconnected or separated from the pixel electrodes ET1 provided in the emission areas EA may be disposed in the non-emission area NEA of the display area DA and the non-display area NA. In an embodiment, for example, the conductive pattern CDP may have a mesh shape with the openings OPN corresponding to the emission areas EA of the pixels PX when viewed from the top of the substrate 110, that is, when viewed in a plan view or when viewed in the third direction DR3.

In an embodiment, the conductive pattern CDP may overlap the pixel electrodes ET1 in areas corresponding to edges of the emission areas EA. However, the conductive pattern CDP is disconnected or separated from the pixel electrodes ET1 with at least one insulating layer interposed therebetween.

The conductive pattern CDP may be connected to at least one auxiliary electrode and/or power line through at least one contact part CNT defined or formed in the non-display area NA or the like (e.g., at least one first contact part CNT1 positioned in the non-display area NA). A first voltage may be applied to the conductive pattern CDP through the auxiliary electrode and/or the power line. In an embodiment, for example, a first voltage may be applied from the auxiliary electrode and/or the power line positioned below the conductive pattern CDP to the conductive pattern CDP through the contact part CNT. The first voltage may be applied or transferred to the mesh-shaped conductive pattern CDP along a direction indicated by a dotted arrow in FIG. 4.

In an embodiment, the first voltage may be a voltage capable of blocking or preventing a leakage current from flowing between the emission areas EA. In an embodiment, for example, the first voltage may be a turn-off voltage of the light emitting element EL, or may be a bias voltage or an initialization voltage corresponding to the turn-off voltage. In an embodiment, the first voltage may be the second source voltage ELVSS or a voltage having a similar level to the second source voltage ELVSS (e.g., a voltage having a difference value corresponding to less than or equal to a threshold voltage of the light emitting element EL as compared with the second source voltage ELVSS). The first voltage may be set to an appropriate value within a range determined to block, prevent, or reduce a leakage current that may occur in the display area DA.

The non-display area NA may be provided with at least one contact part CNT (also referred to as a "first contact part CNT1"). In an embodiment, for example, only one contact part CNT is illustrated in FIG. 4 for convenience of illustration, but a plurality of contact parts CNT may be defined or formed in the non-display area NA surrounding the display area DA. Each contact part CNT may include at least one contact hole and/or via hole.

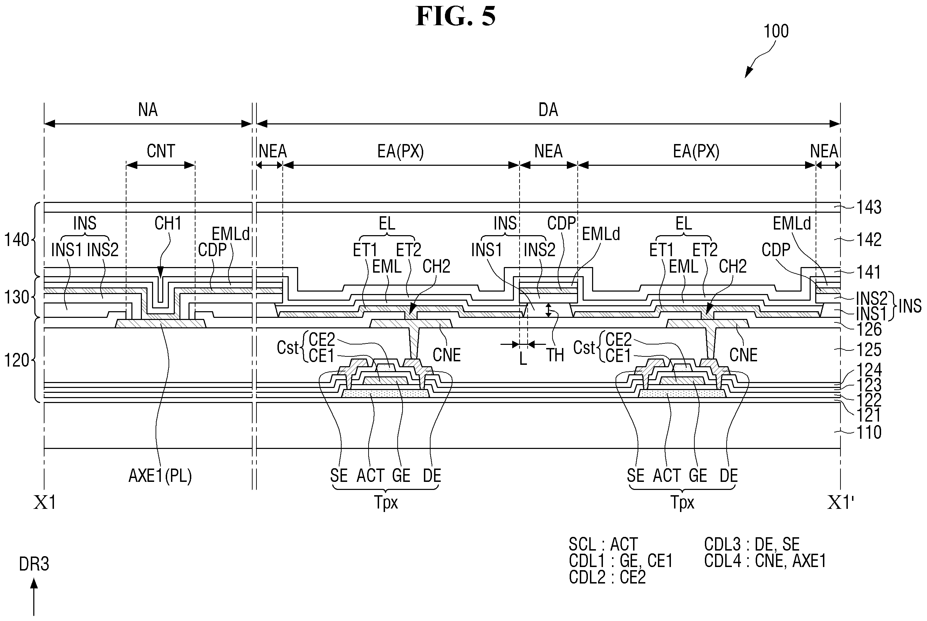

FIG. 5 is a cross-sectional view illustrating the display device 100 according to an embodiment. For example, FIG. 5 schematically illustrates a cross section of an embodiment of the display device 100, taken along line X1-X1' of FIG. 4.

FIG. 5 schematically illustrates cross-sections of one transistor Tpx, a capacitor Cst, and a light emitting element EL among elements provided to each pixel PX. For example, in FIG. 5, among circuit elements provided in the pixel circuit PXC, the transistor Tpx connected to the light emitting element EL and the capacitor Cst connected to a gate electrode GE of the transistor Tpx are illustrated. However, a cross section of the pixel PX may be variously changed depending on a type, a structure, and the like, of each pixel PX. In an embodiment, for example, the capacitor Cst may be connected to one electrode (e.g., a gate electrode) of another transistor provided in the pixel circuit PXC, and one electrode of the capacitor Cst may be integrated with one electrode of another transistor.

Referring to FIG. 5 in addition to FIGS. 1 to 4, the display device 100 may include the substrate 110, and a circuit layer 120, a light emitting element layer 130, and an encapsulation layer 140 that are disposed on the substrate 110. In an embodiment, the circuit layer 120, the light emitting element layer 130, and the encapsulation layer 140 may be sequentially disposed or stacked on the substrate 110 along the third direction DR3.

An embodiment of the display device 100 having a structure in which the light emitting element layer 130 is disposed on the circuit layer 120 is illustrated in FIG. 5, but embodiments are not limited thereto. In an embodiment, for example, the light emitting element layer 130 and the circuit layer 120 may be sequentially disposed on the substrate 110 or the circuit layer 120 and the light emitting element layer 130 may be integrated with each other.

In addition, an embodiment of the display device 100 having a structure in which the light emitting element layer 130 is encapsulated using the encapsulation layer 140 is illustrated in FIG. 5, but embodiments are not limited thereto. In an embodiment, for example, the light emitting element layer 130 may also be encapsulated using a separate upper substrate.

In addition, an embodiment of the display device 100 may further include additional components in addition to the circuit layer 120, the light emitting element layer 130, and/or the encapsulation layer 140. In an embodiment, for example, the display device 100 may further include a sensor layer including a touch sensor or the like, a color filter layer including color filters, color conversion layer including wavelength conversion patterns including wavelength conversion particles, or the like.

The substrate 110 may include or be made of a material having flexible characteristics to be able to be bent, folded, or rolled. The substrate 110 may include or be made of an insulating material such as a polymer resin. In an embodiment, for example, the substrate 110 may include or be made of polyimide. The substrate 110 may include a display area DA including the emission areas EA of the pixels PX and the non-emission area NEA positioned around the emission areas EA, and a non-display area NA positioned around the display area DA.

The circuit layer 120 may include circuit elements constituting the pixel circuit PXC of each pixel PX. In an embodiment, for example, the circuit layer 120 may include a transistor Tpx and a capacitor Cst provided in each pixel circuit PXC. The pixel circuit PXC including the transistor Tpx may be electrically connected to a light emitting element EL of a corresponding pixel PX. The transistor Tpx may include an active layer ACT, a gate electrode GE, a source electrode SE, and a drain electrode DE. The capacitor Cst may include a first capacitor electrode CE1 and a second capacitor electrode CE2.

The circuit layer 120 may further include lines connected to the pixels PX. In an embodiment, for example, the circuit layer 120 may include signal lines including the scan lines SL and the data lines DL, and power lines including the first power line VDL and the second power line VSL.

The circuit layer 120 may include conductive layers for forming (or that define) the circuit elements and the lines, at least one semiconductor layer SCL, and insulating layers provided between the conductive layers and the semiconductor layer SCL. In an embodiment, for example, the circuit layer 120 may include a buffer layer 121, the semiconductor layer SCL, a first insulating layer 122, a first insulating layer CDL1 (e.g., a first gate conductive layer), a second insulating layer 123, a second conductive layer CDL2 (e.g., a second gate conductive layer), a third insulating layer 124, a third conductive layer CDL3 (e.g., a first source-drain conductive layer), and a fourth insulating layer 125 that are sequentially disposed on the substrate 110 in the third direction DR3. In an embodiment, the circuit layer 120 may further include a fourth conductive layer CDL4 (e.g., a second source-drain conductive layer) and a fifth insulating layer 126 that are sequentially disposed on the fourth insulating layer 125. In an embodiment, the circuit layer 120 may further include an additional conductive layer (e.g., a bridge electrode connected to each connection electrode CNE and/or a third source-drain conductive layer including at least one line and the like) disposed on the fifth insulating layer 126 and an insulating layer covering the additional conductive layer. A structure of the circuit layer 120 is not particularly limited, and may be variously changed or modified depending on embodiments.

The buffer layer 121 may include at least one inorganic film including an inorganic insulating material (e.g., silicon nitride, silicon oxide, silicon oxynitride, titanium oxide, aluminium oxide, or other inorganic insulating materials). A material of the buffer layer 121 may be variously changed or modified according to embodiments.

In an embodiment, an additional conductive layer may be disposed between the substrate 110 and the buffer layer 121. In an embodiment, for example, a conductive layer including a light blocking layer overlapping the active layer ACT of at least one transistor Tpx and/or at least one line (or a portion of the at least one line) may be disposed between the substrate 110 and the buffer layer 121.

The semiconductor layer SCL may be provided on one surface of the substrate 110 including the buffer layer 121. The semiconductor layer SCL may include the active layer ACT of each of the transistors Tpx. Each active layer ACT may include polycrystalline silicon, single crystal silicon, low-temperature polycrystalline silicon, amorphous silicon, or an oxide semiconductor material. Each active layer ACT may include a channel region, a source region, and a drain region.

The first insulating layer 122 may cover the semiconductor layer SCL. In an embodiment, the first insulating layer 122 may include at least one inorganic film including an inorganic insulating material.

The first conductive layer CDL1 may be provided on the first insulating layer 122. The first conductive layer CDL1 may include the gate electrode GE of each of the transistors Tpx. Each gate electrode GE may be include a conductive material (e.g., at least one selected from molybdenum (Mo), aluminium (Al), chromium (Cr), gold (Au), titanium (Ti), nickel (Ni), neodymium (Nd), copper (Cu), and other metals, alloys thereof, or other conductive materials) and may be a single-layer or multilayer electrode, i.e., an electrode having a single-layer structure or a multilayer structure.

The third conductive layer CDL1 may further include at least one line (or a portion of the at least one line), a bridge pattern, and/or a capacitor electrode. In an embodiment, for example, the first conductive layer CDL1 may further include the first capacitor electrode CE1 of the capacitor Cst. In an embodiment, the first capacitor electrode CE1 may be formed integrally with the gate electrode GE of the transistor Tpx connected thereto. An embodiment, in which the first capacitor electrode CE1 is formed integrally with the gate electrode GE of the transistor Tpx connected to the light emitting element EL, is illustrated in FIG. 5, but embodiments are not limited thereto. In an embodiment, for example, depending on a structure of the pixel circuit PXC, the transistor Tpx whose gate electrode GE is directly connected to the first capacitor electrode CE1 may also be connected to the light emitting element EL via another transistor or the like.

The second insulating layer 123 may cover the first conductive layer CDL1. In an embodiment, the second insulating layer 123 may include at least one inorganic film including an inorganic insulating material.

The second conductive layer CDL2 may be provided on the second insulating layer 123. The second conductive layer CDL2 may further include at least one line (or a portion of the at least one line), a bridge pattern, and/or a capacitor electrode. As an example, the second conductive layer CDL2 may include the second capacitor electrode CE2 of the capacitor Cst. The first capacitor electrode CE1 and the second capacitor electrode CE2 of the capacitor Cst may overlap each other in a thickness direction of the substrate 110 or in the third direction DR3. In an embodiment, when each pixel PX further includes at least one transistor formed at a different layer from the transistors Tpx illustrated in FIG. 5, the second conductive layer CDL2 may further include a gate electrode (or a back gate electrode) of the at least one transistor, and the like.

The third insulating layer 124 may cover the second conductive layer CDL2. In an embodiment, the third insulating layer 124 may include at least one inorganic film including an inorganic insulating material.

The third conductive layer CDL3 may be provided on the third insulating layer 124. The third conductive layer CDL3 may include the source electrode SE and the drain electrode DE of each of the transistors Tpx. Each of the source electrode SE and the drain electrode DE may include a conductive material and may be a single-layer or multilayer electrode. In another embodiment, the source electrode SE and/or the drain electrode DE of each of the transistors Tpx may be formed as (or defined by) the source region and/or the drain region of the active layer ACT, and the third conductive layer CDL3 may include at least one bridge electrode connected to the source electrode SE and/or the drain electrode DE of at least one transistor Tpx, or the like. In an embodiment, the third conductive layer CDL3 may further include at least one line (or a portion of the at least one line), a bridge pattern, and/or a capacitor electrode. In an embodiment, for example, the third conductive layer CDL3 may further include the first power line VDL (or a portion of the first power line VDL) and/or the second power line VSL (or a portion of the second power line VSL).

The fourth insulating layer 125 may cover the third conductive layer CDL3. In an embodiment, the fourth insulating layer 125 may include at least one organic film including an organic insulating material (e.g., an acrylic resin, an epoxy resin, a phenolic resin, a polyamide resin, a polyimide resin, or other organic insulating materials) in order to planarize the circuit layer 120, but is not limited thereto.

The fourth conductive layer CDL4 may be provided on the fourth insulating layer 125. The fourth conductive layer CDL4 may include connection electrodes CNE (or bridge electrodes) for connecting the transistors Tpx to respective light emitting elements EL. Each connection electrode CNE may be disposed on each transistor Tpx, and may electrically connect the transistor Tpx to the light emitting element EL of the corresponding pixel PX. Each connection electrode CNE may include a conductive material and may be a single-layer or multilayer electrode. In an embodiment, the fourth conductive layer CDL4 may further include at least one line (or a portion of the at least one line), a bridge pattern, and/or a capacitor electrode. In an embodiment, for example, the fourth conductive layer CDL4 may further include the first power line VDL (or a portion of the first power line VDL) and/or the second power line VSL (or a portion of the second power line VSL).

The fourth conductive layer CDL4 may further include at least one first electrode AXE1 (also referred to as an "auxiliary electrode" or a "first auxiliary electrode") provided at a position corresponding to at least one contact part CNT. In an embodiment, for example, the fourth conductive layer CDL4 may include at least one first electrode AXE1 provided at a position corresponding to at least one contact part CNT positioned in the non-display area NA. In an embodiment, for example, the fourth conductive layer CDL4 may include a plurality of first electrodes AXE1 each provided at positions corresponding to a plurality of contact parts CNT distributed in the non-display area NA.

The first electrode AXE1 may be connected to the conductive pattern CDP through a first contact hole CH1 defined or formed in each contact part CNT. In an embodiment, for example, the conductive pattern CDP is disposed on the first electrode AXE1 exposed by the first contact hole CH1 in each contact part CNT, such that the first electrode AXE1 and the conductive pattern CDP may be electrically connected to each other. In an embodiment, the first electrode AXE1 may be formed simultaneously with the connection electrodes CNE of the display area DA by a same process.

In an embodiment, the first electrode AXE1 may be connected to a power line PL (e.g., the second power line VSL) to which the first voltage is applied or may be a portion of the power line PL. Accordingly, the first voltage may be applied to the conductive pattern CDP through the first electrode AXE1. In an embodiment, the first electrode AXE1 may be provided in the non-display area NA.

An embodiment, in which the first electrode AXE1 is provided at the fourth conductive layer CDL4, is illustrated in FIG. 5, but a position of the first electrode AXE1 may be variously changed or modified depending on embodiments. In an embodiment, for example, the first electrode AXE1 may also be provided at another conductive layer (e.g., the first conductive layer CDL1, the second conductive layer CDL2, and/or the third conductive layer CDL3) provided in the circuit layer 120.

In addition, an embodiment, in which the first electrode AXE1 is provided at a single conductive layer, is illustrated in FIG. 5, but embodiments are not limited thereto. In an embodiment, for example, the first electrode AXE1 may also be a multi-layer electrode or line provided at at least two conductive layers provided in the circuit layer 120.

In an embodiment, the display device 100 may not include the fourth conductive layer CDL4. In such an embodiment, one electrodes of the transistors Tpx provided at the third conductive layer CDL3 (or the bridge electrodes provided at the third conductive layer CDL3 and connected to the active layers ACT of the transistors Tpx) may be directly connected to the respective light emitting elements EL.

The fifth insulating layer 126 may cover a conductive layer at which the first electrode AXE1 or the like are provided, for example, the fourth conductive layer CDL4. In an embodiment, the fifth insulating layer 126 may include at least one inorganic film including an inorganic insulating material, but is not limited thereto. In an embodiment, for example, the fifth insulating layer 126 may also include an organic film.

The fifth insulating layer 126 may be provided with an opening (e.g., a first contact hole CH1) defined therethrough to expose a portion of the first electrode AXE1. In an embodiment, for example, the fifth insulating layer 126 may be opened to expose a portion of the first electrode AXE1 at a position corresponding to the contact part CNT. The opening of the fifth insulating layer 126 formed on the first electrode AXE1 may define a position where the contact part CNT will be formed.

In addition, the fifth insulating layer 126 may be provided with openings (e.g., second contact holes CH2) defined therethrough to expose portions of the respective connection electrodes CNE. In an embodiment, for example, the fifth insulating layer 126 may be opened to expose portions of the respective connection electrode CNE at positions corresponding to the respective connection electrodes CNE. The openings of the fifth insulating layer 126 formed on the respective connection electrodes CNE may define positions where the light emitting elements EL and the pixel circuits PXC (or the connection electrodes CNE) will be connected to each other.

The light emitting element layer 130 may include an insulating layer INS defining and/or partitioning the emission areas EA and the contact part CNT, the light emitting elements EL positioned in the respective emission areas EA, and the conductive pattern CDP disposed on the insulating layer INS.

The insulating layer INS is positioned in the non-emission area NEA positioned between the emission areas EA and the non-display area NA on the substrate 110. In an embodiment, for example, the insulating layer INS may be disposed on the circuit layer 120 (e.g., on the fifth insulating layer 126), and may be positioned in the non-emission area NEA and the non-display area NA. The insulating layer INS may surround the emission areas EA and define the respective emission areas EA. The emission areas EA of two adjacent pixels PX may be spaced apart from each other by a distance corresponding to a width of the insulating layer INS positioned therebetween. Accordingly, the emission areas EA may be appropriately defined and/or partitioned without forming a separate pixel defining film or the like on the pixel electrodes ET1 of the light emitting elements EL, such that a structure and a manufacturing process of the display device 100 may be simplified and a degree of freedom in design of the display device 100 may be increased.

The insulating layer INS may define openings corresponding to the emission areas EA and the contact part CNT, and surround the emission areas EA and the contact part CNT (e.g., the first contact hole CH1). In an embodiment, for example, the insulating layer INS may be an insulating pattern having a position and a shape (e.g., a mesh shape) corresponding to those of the conductive pattern CDP illustrated in FIG. 4 when viewed from the top of the substrate 110 or when viewed in the third direction DR3.

The insulating layer INS may have a shape, a structure, a thickness, and/or a height where the respective pixel electrodes ET1 may be formed in the emission areas EA to be automatically (or naturally) and/or immediately separated (e.g., disconnected) from each other simultaneously with application (e.g., deposition) of a conductive material in a process of forming a conductive film for forming the respective pixel electrodes ET1 (e.g., anode electrodes of the light emitting elements EL) in the emission areas EA. Accordingly, even in a high-resolution display device in which an area of each of the pixels PX and/or a distance between the pixels PX are substantially small or reduced compared to a display device having a relatively low resolution, the pixel electrodes ET1 and/or the conductive pattern CDP may be easily separated from each other and/or be patterned. In an embodiment, for example, instead of patterning the pixel electrodes ET1 using a high-resolution mask corresponding to the emission areas EA, the respective pixel electrodes ET1 may be formed in the emission areas EA to be separated from each other by entirely applying the conductive material onto the substrate 110 on which the insulating layer INS and the like are formed. Accordingly, in an embodiment as described above, a distance between the emission areas EA spaced apart from each other may be appropriately reduced or minimized as desired without a difficulty or a limitation in process due to a high-resolution mask process. In addition, the pixel electrodes ET1 are formed to be stably and/or easily separated from each other by the insulating layer INS, such that it is possible to simplify and facilitate the manufacturing process of the display device 100 and effectively prevent or substantially reduce a defect of the display device 100.

In an embodiment, the insulating layer INS is at least a double-layer insulating film or insulating pattern. In an embodiment, for example, the insulating layer INS may include a lower insulating layer INS1 having a thickness (or a height) greater than a thickness of each of the pixel electrodes ET1 and an upper insulating layer INS2 disposed on the lower insulating layer INS 1.

In an embodiment, the lower insulating layer INS1 may have a thickness less than or equal to the sum of thicknesses of the pixel electrode ET1, a light emitting layer EML, and a common electrode ET2 that constitute each light emitting element EL, and the light emitting elements EL may share the common electrode ET2 formed as a single unitary pattern with each other. In an embodiment, for example, the common electrode ET2 of the light emitting elements EL may be formed as a common film covering (extending over) the conductive pattern CDP or the like disposed in the non-emission area NEA, and may be entirely disposed in the display area DA including the emission areas EA and the non-emission area NEA.

The lower insulating layer INS1 is positioned between the pixel electrodes ET1 positioned in the respective emission areas EA in the display area DA. In an embodiment, for example, the lower insulating layer INS1 may be positioned in the non-emission area NEA so as to be positioned between and/or around the pixel electrodes ET1 in the display area DA, and may surround the respective pixel electrodes ET1. The lower insulating layer INS1 may be disposed on the fifth insulating layer 126 in the non-display area NA, and may include an opening (e.g., a first contact hole CH1) corresponding to the contact part CNT.

The upper insulating layer INS2 is disposed on the lower insulating layer INS1. In an embodiment, for example, the upper insulating layer INS2 may be positioned in the non-emission area NEA between the emission areas EA in the display area DA, and may be positioned at a greater height than the pixel electrodes ET1. The upper insulating layer INS2 may be disposed on the lower insulating layer INS1 in the non-display area NA, and may include an opening (e.g., a first contact hole CH1) corresponding to the contact part CNT.

In an embodiment, the lower insulating layer INS1 and the upper insulating layer INS2 have different areas at an interface where the lower insulating layer INS 1 and the upper insulating layer INS2 are in contact with each other, and the upper insulating layer INS2 may protrude outward more than the lower insulating layer INS1 at the interface. The upper insulating layer INS2 has a greater area than an upper surface of the lower insulating layer INS1. In an embodiment, for example, the upper insulating layer INS2 may have an area at least greater than the upper surface of the lower insulating layer INS 1, and may completely cover the upper surface of the lower insulating layer INS 1. Accordingly, on a side surface of the insulating layer INS, the upper insulating layer INS2 may protrude outward more than the lower insulating layer INS 1. In an embodiment having the structure described above, the pixel electrodes ET1 may be more stably separated from each other and patterned in a process of applying the conductive material for forming the pixel electrodes ET1. In an embodiment, the upper insulating layer INS2 may overlap the pixel electrodes ET1 at the edges of the emission areas EA.

The lower insulating layer INS1 and the upper insulating layer INS2 may include different insulating materials. In an embodiment, for example, the lower insulating layer INS1 may include an organic insulating film of at least one layer including an organic insulating material, and the upper insulating layer INS2 may include an inorganic insulating film of at least one layer including an inorganic insulating material. In an embodiment, for example, the lower insulating layer INS1 may be an organic insulating layer including a polyacrylate resin, an epoxy resin, a phenolic resin, a polyamide resin, a polyimide resin, an unsaturated polyester resin, a polyphenylene ether resin, a polyphenylenesulfide resin, benzocyclobutene (BCB), or other organic insulating materials, and the upper insulating layer INS2 may be an inorganic insulating layer including silicon nitride, silicon oxide, silicon oxynitride, titanium oxide, aluminium oxide, or other inorganic insulating materials. In an embodiment, the lower insulating layer INS1 may be patterned through an etching process using the upper insulating layer INS2 as a mask.

The conductive pattern CDP may be disposed on the insulating layer INS. For example, the conductive pattern CDP may be separated from the pixel electrodes ET1 of the pixels PX and disposed on the upper insulating layer INS2.

In an embodiment, the conductive pattern CDP may be formed simultaneously with the pixel electrodes ET1 in a process of forming the pixel electrodes ET1, including the process of applying the conductive material for forming the pixel electrodes ET1, and may be automatically or naturally separated from the pixel electrodes ET1 by the insulating layer INS. In an embodiment, for example, the conductive pattern CDP is formed using the conductive material for forming the pixel electrodes ET1, and may include the same conductive material as the pixel electrodes ET1.

The conductive pattern CDP may be connected to the first electrode AXE1 positioned below the insulating layer INS through the first contact hole CH1 defined through the insulating layer INS in the contact part CNT. The conductive pattern CDP may receive the first voltage supplied through the first electrode AXE1 and/or the power line PL connected to the first electrode AXE1.

In an embodiment, a dummy light emitting layer EMLd may be disposed on the conductive pattern CDP. The dummy light emitting layer EMLd may be formed simultaneously with the light emitting layer EML in a process of forming the light emitting layer EML of each of the light emitting elements EL, and may be separated from the light emitting layer EML of each of the light emitting elements EL. In an embodiment, for example, the thickness of the lower insulating layer INS1 may be greater than the sum of the thicknesses of the pixel electrode ET1 and the light emitting layer EML of each of the light emitting elements EL, and the light emitting layers EML may be formed in the respective emission areas EA to be separated from each other simultaneously with entirely applying a material for forming the light emitting layer EML to the display area DA or the like in a process of forming the light emitting layers EML. In this process, the light emitting layers EML of the light emitting elements EL provided in the pixels PX may be separated from each other with the lower insulating layer INS1 interposed therebetween. In addition, in the non-emission area NEA and the non-display area DA, the dummy light emitting layer EMLd separated from the light emitting layers EML of the light emitting elements EL may be formed on the conductive pattern CDP. Even though the dummy light emitting layer EMLd or the like is disposed on the conductive pattern CDP, the occurrence of a leakage current in the display area DA may be blocked, prevented, and/or reduced by applying the first voltage to the conductive pattern CDP.

Each light emitting element EL may include the pixel electrode ET1 (e.g., the anode electrode of the light emitting element EL) disposed in each emission area EA, the light emitting layer EML disposed on the pixel electrode ET1, and the common electrode ET2 (e.g., a cathode electrode of the light emitting element EL) disposed on the light emitting layer EML. In an embodiment, each light emitting element EL may be connected to the transistor Tpx of the pixel circuit PXC through at least one connection electrode CNE provided in the corresponding pixel PX. In an embodiment, for example, the pixel electrode ET1 of each pixel PX may be electrically connected to at least one transistor Tpx provided in the pixel circuit PXC of the corresponding pixel PX through each connection electrode CNE.

The pixel electrode ET1 may include a conductive material, and may be disposed on the circuit layer 120. In an embodiment, for example, the pixel electrode ET1 may be disposed on the fifth insulating layer 126 so as to correspond to each emission area EA, and may be connected to the connection electrode CNE through the second contact hole CH2. In an embodiment, the pixel electrode ET1 may include a metal material having high reflectivity. In an embodiment, for example, the pixel electrode ET1 may have a single-layer structure of molybdenum (Mo), titanium (Ti), copper (Cu), or aluminium (Al) or have a multilayer structure (e.g., ITO/Mg, ITO/MgF, ITO/Ag, ITO/Ag/ITO, etc.) including indium-tin-oxide (ITO), indium-zinc-oxide (IZO), zinc oxide (ZnO), or indium oxide (In₂O₃), and silver (Ag), magnesium (Mg), aluminium (Al), platinum (Pt), lead (Pb), gold (Au), nickel (Ni), or the like.

The light emitting layer EML may include a high molecular material or a low molecular material. Light emitted from the light emitting layer EML may contribute to image display. In an embodiment, the pixels PX may include the light emitting layers EML including the same type, structure, and/or material and emitting light of a specific color (e.g., white light or blue light), and color filters and/or wavelength conversion patterns corresponding to colors (or wavelength bands) of light to be emitted from the respective pixels PX may be disposed in the emission areas EA of at least some pixels PX. In an embodiment, for example, a light conversion layer including color filters and/or wavelength conversion patterns may be provided above the light emitting element layer 130 (e.g., between the light emitting element layer 130 and the encapsulation layer 140, above the encapsulation layer 140, or between the light emitting element layer 130 and a separate upper substrate). In another embodiment, the light emitting layer EML may be provided for each pixel PX or each of pixels PX of a specific color, and the light emitting layer EML of each pixel PX may emit light of a color corresponding to the corresponding pixel PX. The display device 100 in which the light emitting layer EML of each pixel PX emits the light of the color corresponding to the corresponding pixel PX may or may not include the light conversion layer including the color filters and/or the wavelength conversion patterns.

The common electrode ET2 may include a conductive material, and may be connected to the second power line VSL. In an embodiment, the common electrode ET2 may include or be made of a transparent conductive material (TCO) such as ITO or IZO capable of transmitting light therethrough or a semi-transmissive conductive material such as magnesium (Mg), silver (Ag), or an alloy of magnesium (Mg) and silver (Ag). In an embodiment where the common electrode ET2 include or is made of the semi-transmissive conductive material, an improvement in light emission efficiency due to a micro cavity effect may be expected.

In an embodiment, the common electrode ET2 may be a common film entirely formed in at least the display area DA and shared by the light emitting elements EL of the pixels PX. In an embodiment, for example, the common electrode ET2 may be entirely formed on the light emitting layers EML positioned in the emission areas EA and the dummy light emitting layer EMLd positioned in the non-emission area NEA. In an embodiment, the common electrode ET2 may be formed to extend to at least a portion of the non-display area NA, and the contact part CNT may be formed in an area in which the common electrode ET2 is disposed.

In an embodiment, by adjusting the shape, the structure, the thickness, the height, and the like, of the insulating layer INS, it is possible to control whether or not to separate (e.g., whether or not to pattern) the pixel electrodes ET1, the light emitting layers EML, and/or the common electrode ET2 provided in the emission areas EA from each other. In an embodiment, for example, by adjusting a thickness TH (or a height) of the lower insulating layer INS1, a length L of an end of the upper insulating layer INS2 protruding more than the lower insulating layer INS1, and the like, it is possible to control whether or not to separate and/or pattern each of the pixel electrodes ET1, the light emitting layers EML, and/or the common electrode ET2 from each other.

The encapsulation layer 140 may be disposed on the light emitting element layer 130 in the display area DA and the non-display area NA positioned around the display area DA. The encapsulation layer 140 may block penetration of oxygen or moisture into the light emitting element layer 130 and alleviate an electrical or physical impact on the circuit layer 120 and the light emitting element layer 130.

In an embodiment, the encapsulation layer 140 may include a first encapsulation layer 141, a second encapsulation layer 142, and a third encapsulation layer 143 that are sequentially disposed on the light emitting element layer 130. The first encapsulation layer 141 and the third encapsulation layer 143 may include an inorganic insulating material, and the second encapsulation layer 142 may include an organic insulating material.

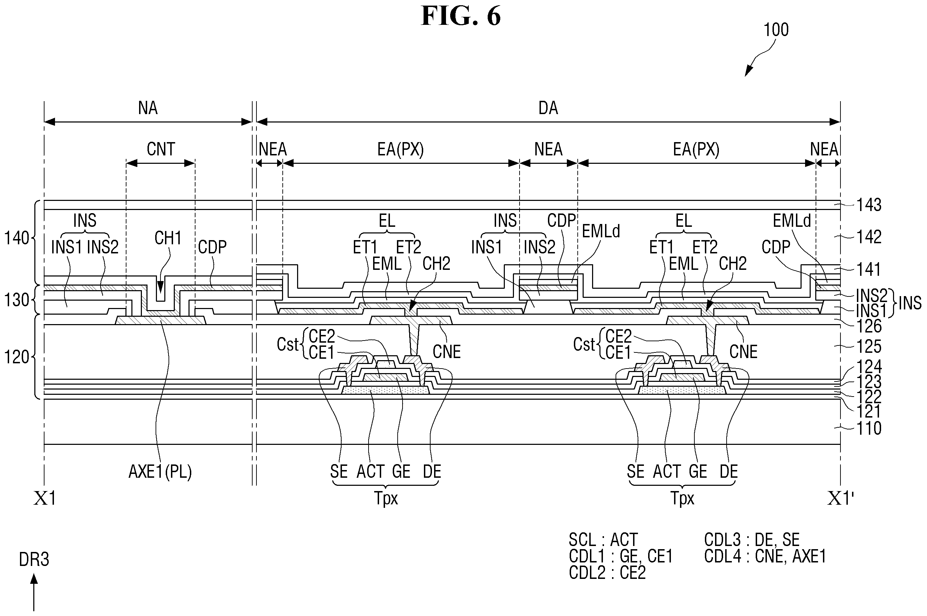

FIG. 6 is a cross-sectional view illustrating the display device 100 according to an embodiment. For example, FIG. 6 schematically illustrates an embodiment of a cross section of the display device 100, taken along line X1-X1' of FIG. 4, and illustrates an embodiment different from an embodiment of FIG. 5 in relation to a portion of the non-display area NA in which the first electrode AXE1 and the contact part CNT are positioned.

Referring to FIG. 6 in addition to FIGS. 1 to 5, in an embodiment, the first electrode AXE1 and the contact part CNT may be positioned in a portion of the non-display area NA in which the dummy light emitting layer EMLd and the common electrode ET2 are not provided and only the conductive pattern CDP is provided. In an embodiment, for example, the dummy light emitting layer EMLd and the common electrode ET2 may be provided only in the display area DA or be positioned only in the display area DA and a portion of the non-display area NA positioned around the display area DA. The first electrode AXE1 and the contact part CNT may be positioned in another portion of the non-display area NA in which the dummy light emitting layer EMLd and the common electrode ET2 are not provided (e.g., an edge area of the non-display area NA). Positions, the numbers, and the like, of the first electrodes AXE1 and the contact parts CNT may be variously changed depending on embodiments.

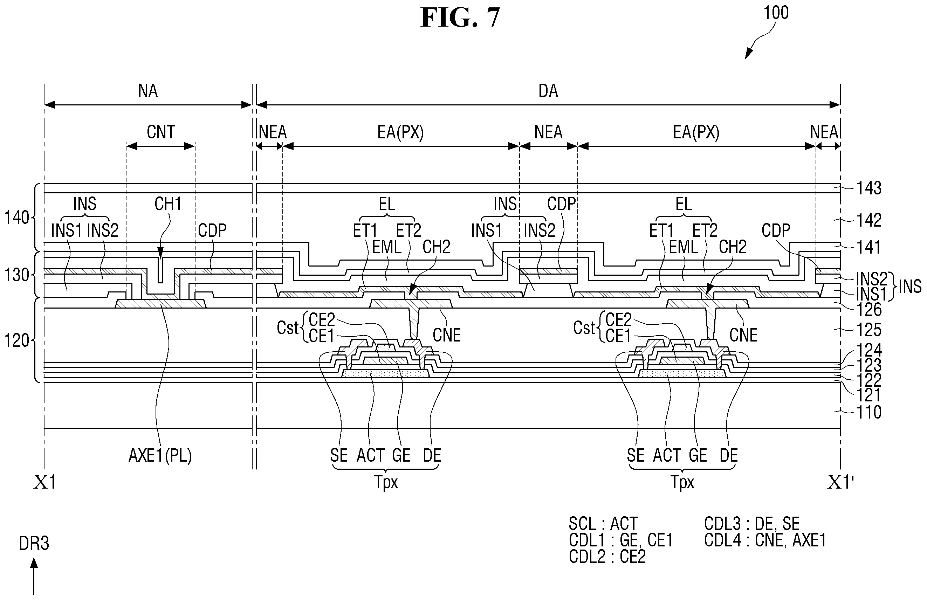

FIG. 7 is a cross-sectional view illustrating the display device 100 according to an embodiment. For example, FIG. 7 schematically illustrates an embodiment of a cross section of the display device 100, taken along line X1-X1' of FIG. 4, and illustrates an embodiment different from an embodiment of FIG. 5 in relation to the light emitting layer EML.

Referring to FIG. 7 in addition to FIGS. 1 to 6, in an embodiment, a thickness of the lower insulating layer INS1 may be less than or equal to the sum of thicknesses of each pixel electrode ET1 and light emitting layer EML, and a height of the light emitting layer EML may be greater than or equal to a height of the insulating layer INS 1. The light emitting layer EML may be a common film shared by the light emitting elements EL of the pixels PX. In an embodiment, for example, the light emitting layer EML of the pixels PX may be formed as a common film covering the conductive pattern CDP, and may be entirely disposed in the display area DA or the like including the emission areas EA and the non-emission area NEA. Even though the light emitting layer EML is entirely formed in the display area DA, a leakage current may be blocked or prevented because the first voltage is applied to the conductive pattern CDP in the non-emission area NEA.

In an embodiment, the light emitting layer EML may be a light emitting layer of a tandem structure including at least two light emitting layers sequentially stacked between the pixel electrode ET1 and the common electrode ET2 and at least one charge generation layer disposed between the light emitting layers (e.g., a light emitting stack including a plurality of light emitting layers, intermediate layers, and at least one charge generation layer). In another embodiment, the light emitting layer EML may be a single-layer light emitting layer or be a light emitting stack that includes a plurality of light emitting layers, but does not include a charge generation layer. In addition, a type, a structure, and the like, of the light emitting layer EML may be variously changed depending on embodiments.

In an embodiment, the light emitting layer EML may generate light of the same color (e.g., white light or blue light) in the emission areas EA of the pixels PX. In addition, respective color filters and/or wavelength conversion patterns corresponding to colors of light to be emitted from the respective pixels PX may be disposed on the light emitting elements EL of the pixels PX.

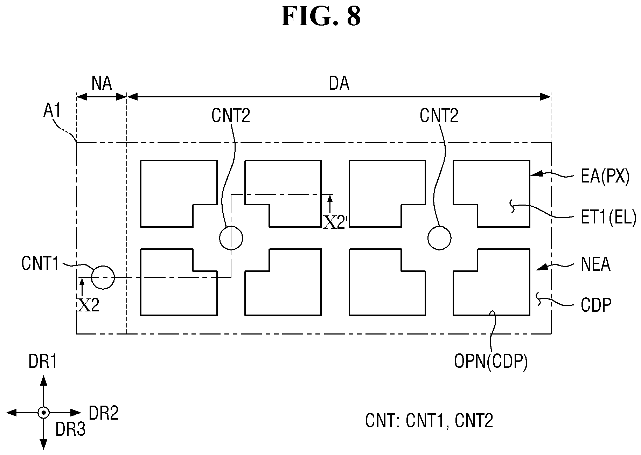

FIG. 8 is a schematic plan view illustrating a portion of the display device 100 corresponding to area A1 of FIG. 1. For example, FIG. 8 illustrates an embodiment different from an embodiment of FIG. 4 in relation to the contact part CNT.

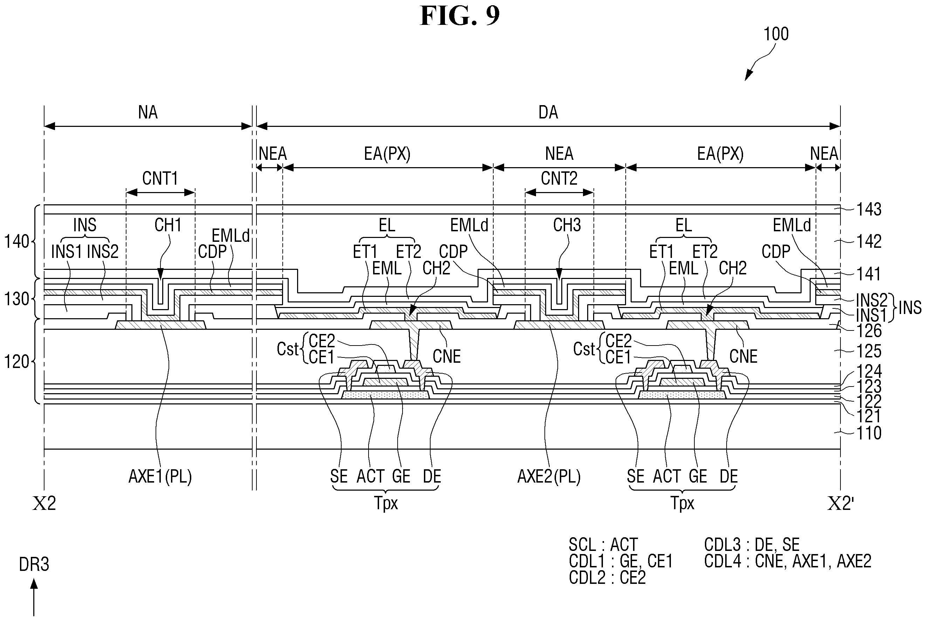

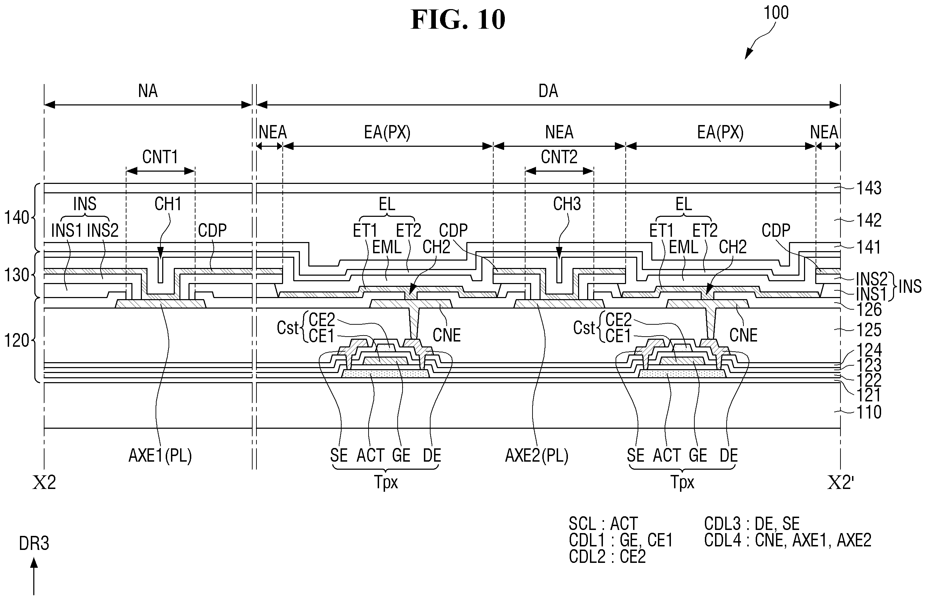

FIG. 9 is a cross-sectional view illustrating the display device 100 according to an embodiment. FIG. 10 is a cross-sectional view illustrating the display device 100 according to an embodiment. For example, FIGS. 9 and 10 illustrate different embodiments of a cross section of the display device 100, taken along line X2-X2' in FIG. 8, and illustrate modified embodiments different from an embodiment of FIG. 5 and an embodiment of FIG. 7.

Referring to FIGS. 8 to 10 in addition to FIGS. 1 to 7, an embodiment of the display device 100 may further include at least one contact part CNT positioned in the display area DA. In an embodiment, for example, the display device 100 may include at least one first contact part CNT1 positioned in the non-display area NA and at least one second contact part CNT2 positioned in the non-emission area NEA of the display area DA. In addition, the display device 100 may further include at least one second electrode AXE2 (also referred to as a "second auxiliary electrode") positioned in the non-emission area NEA so as to correspond to each second contact part CNT2.

In an embodiment, the second electrode AXE2 may be provided at the same conductive layer as the first electrode AXE1, and may be formed simultaneously with the first electrode AXE1. In an embodiment, for example, the second electrode AXE2 may be provided at the fourth conductive layer CDL4 including the connection electrodes CNE and the first electrode AXE1.

In an embodiment, the first electrode AXE1 and the second electrode AXE2 may be supplied with a same first voltage. In an embodiment, for example, the first electrode AXE1 and the second electrode AXE2 may be connected to the power line PL (e.g., the second power line VSL) to which the first voltage is applied or may be portions of the power line PL. Accordingly, the first voltage may be applied to the conductive pattern CDP through the first electrode AXE1 and the second electrode AXE2. The first voltage may be more stably applied to the conductive pattern CDP through the first electrode AXE1 and the second electrode AXE2, and accordingly, a leakage current may be more effectively blocked, prevented, or reduced.

The second electrode AXE2 may be connected to the conductive pattern CDP through a third contact hole CH3 defined through the insulating layer INS disposed on the second electrode AXE2 in each second contact part CNT2. In an embodiment, for example, the conductive pattern CDP is disposed on the second electrode AXE2 exposed by the third contact hole CH3 in each second contact part CNT2, such that the second electrode AXE2 and the conductive pattern CDP may be electrically connected to each other.

In addition, positions, the numbers, distribution densities, or the like, of the contact parts CNT and the auxiliary electrodes (e.g., the first electrode AXE1 and/or the second electrode AXE2) connected to the contact parts CNT may be variously changed depending on embodiments. In an embodiment, for example, in another embodiment, the contact part CNT and the auxiliary electrode may not be provided in the non-display area NA, and may be provided only in the display area DA.

In an embodiment, the insulating layer INS may have a relatively expanded width in an area in which the second contact part CNT2 is positioned so as to appropriately surround the second contact part CNT2. In addition, the emission areas EA defined by the insulating layer INS may have a shape corresponding to that of the insulating layer INS. In an embodiment, for example, the emission areas EA may have a relatively reduced width around the second contact part CNT2. The pixel electrodes ET1 may have a shape and/or an area corresponding to that of the respective emission areas EA.

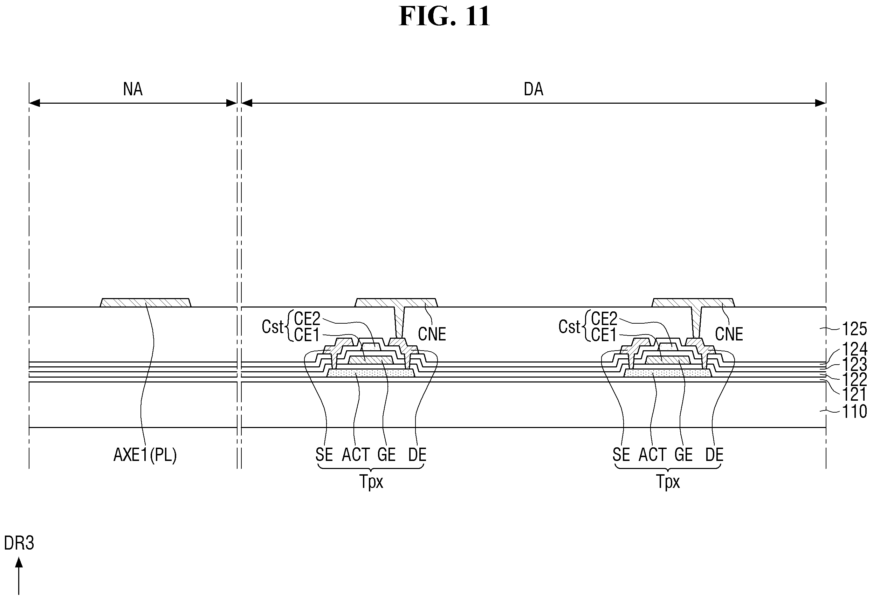

FIGS. 11 to 19 are cross-sectional views illustrating a method for manufacturing the display device 100 according to an embodiment. For example, FIGS. 11 to 19 sequentially illustrate a method for manufacturing the display device 100 according to an embodiment of FIG. 5.

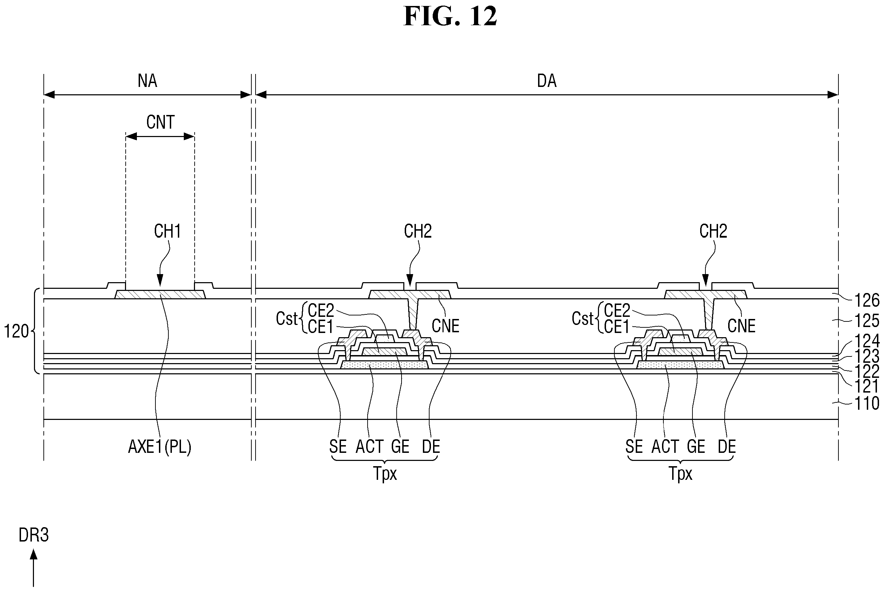

Referring to FIGS. 11 and 12 in addition to FIGS. 1 to 10, in an embodiment of a method for manufacturing the display device 100, the substrate 110 including the display area DA and the non-display area NA may be prepared. In addition, the circuit layer 120 may be formed on the substrate 110.

For example, as illustrated in FIG. 11, the buffer layer 121, the circuit elements of the pixel circuit PXC including the transistors Tpx, the first to fourth insulating layers 122, 123, 124, and 125, the connection electrodes CNE connected to the transistors Tpx, and the first electrode AXE1 connected to the power line PL or the like may be formed on the substrate 110. In a case where an embodiment of the display device 100 further including the second electrode AXE2 as shown in FIGS. 8 to 10 is manufactured, the second electrode AXE2 may be further formed in the circuit layer 120. In an embodiment, for example, in a process of forming the circuit elements including the transistors Tpx and/or the connection electrodes CNE on the substrate 110, auxiliary electrodes including the first electrode AXE1 and/or the second electrode AXE2 may be formed. In addition, in a process of forming the circuit elements, the connection electrodes CNE, the first electrode AXE1, and/or the second electrode AXE2, lines provided in the display panel together with the pixels PX may be formed.

The circuit elements of the pixel circuit PXC including the transistors Tpx and the connection electrodes CNE may be formed in the respective pixel areas (e.g., the pixel areas including the respective emission areas EA illustrated in FIGS. 4 and 5). In an embodiment having a structure where one electrode of each of the transistors Tpx is directly connected to the light emitting element EL of the corresponding pixel PX, the connection electrodes CNE may not be formed.

The auxiliary electrodes (e.g., the first electrode AXE1 and/or the second electrode AXE2) may be provided at at least one of the conductive layers of the circuit layer 120 including the transistors Tpx, the lines, and/or the connection electrodes CNE, and may be formed simultaneously with electrodes, lines, and/or bridge patterns provided at the at least one conductive layer. The first electrode AXE1 may be formed in the non-display area NA. The second electrode AXE2 may be formed in the non-emission area NEA of the display area DA.

Thereafter, as illustrated in FIG. 12, the fifth insulating layer 126 may be formed on the substrate 110 on which the auxiliary electrode including the first electrode AXE1, the transistors Tpx, the connection electrodes CNE, and the like, are formed. In an embodiment, for example, the fifth insulating layer 126 provided with the first contact hole CH1 and the second contact holes CH2 may be formed by applying an inorganic insulating material onto the substrate 110 on which the first electrode AXE1, the transistors Tpx, the connection electrodes CNE, and the like, are formed to form an inorganic insulating layer and etching the inorganic insulating layer so that portions of the first electrode AXE1 and each of the connection electrodes CNE are exposed.

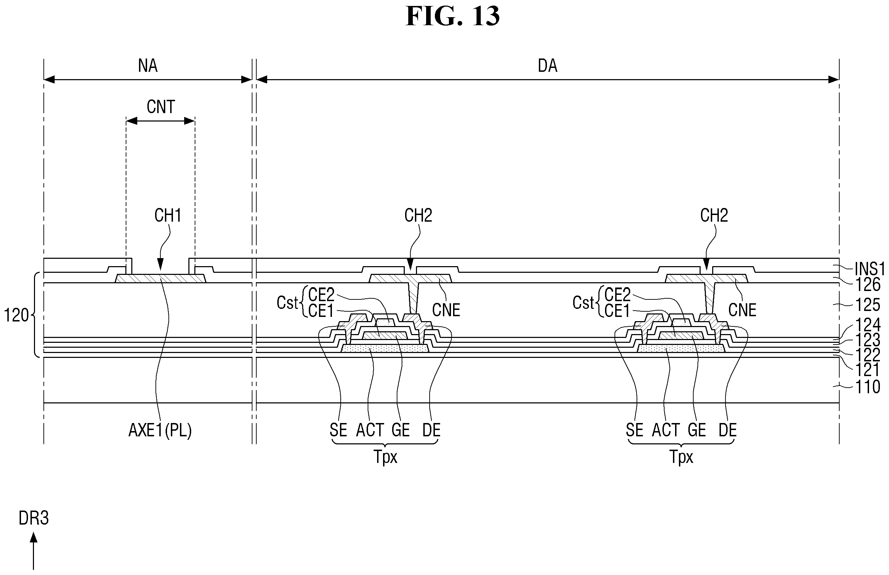

Referring to FIGS. 13 to 16 in addition to FIGS. 1 to 12, the insulating layer INS including the lower insulating layer INS 1 and the upper insulating layer INS2 may be formed on the substrate 110 on which the auxiliary electrode including the first electrode AXE1, the transistors Tpx, the connection electrodes CNE, the fifth insulating layer 126, and the like, are formed.

For example, as illustrated in FIG. 13, the lower insulating layer INS1 may be formed by applying an organic insulating material onto the substrate 110 on which the auxiliary electrode including the first electrode AXE1, the transistors Tpx, the connection electrodes CNE, the fifth insulating layer 126, and the like, are formed. In addition, the lower insulating layer INS1 may be etched so that a portion of the first electrode AXE1 is exposed in an area corresponding to the contact part CNT. In a case where an embodiment of the display device 100 including the second electrode AXE2 is manufactured, the lower insulating layer INS1 may be etched on the second electrode AXE2 so that a portion of the second electrode AXE2 is exposed.

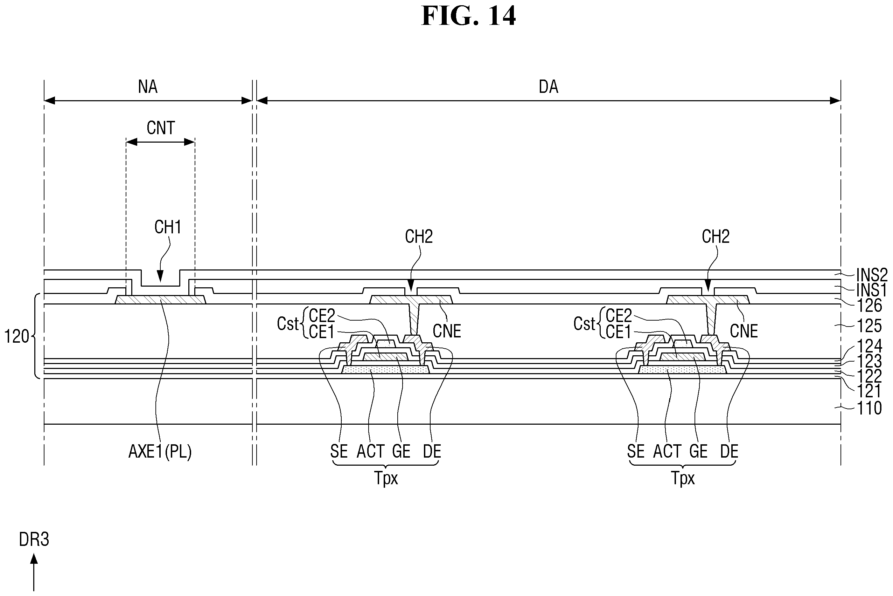

Thereafter, as illustrated in FIG. 14, the upper insulating layer INS2 may be entirely formed by applying an inorganic insulating material onto the substrate 110 on which the lower insulating layer INS1 and the like are formed.

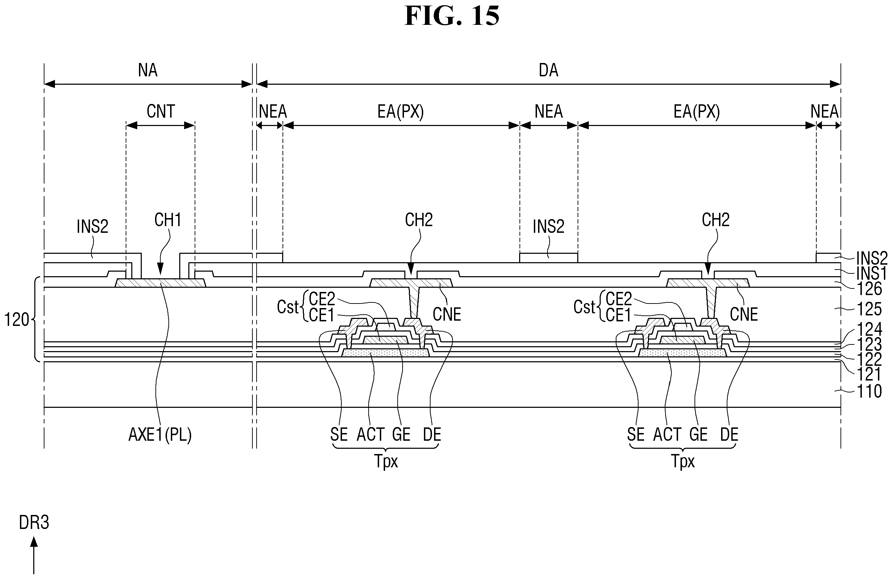

Thereafter, as illustrated in FIG. 15, the upper insulating layer INS2 may be etched so that a portion of the first electrode AXE1 is exposed in the area corresponding to the contact part CNT of the non-display area NA and the lower insulating layer is exposed in the emission areas EA. Accordingly, the upper insulating layer INS2 may be patterned to match an area in which the insulating layer INS is to be formed. In an embodiment, the upper insulating layer INS2 may prevent the opening of the lower insulating layer INS 1 positioned on the first electrode AXE1 from being additionally etched in a subsequent process by covering side surfaces of the lower insulating layer INS1 in the area corresponding to the contact part CNT. In a case where an embodiment of the display device 100 including the second electrode AXE2 is manufactured, the upper insulating layer INS2 may be etched on the second electrode AXE2 so that a portion of the second electrode AXE2 is exposed.

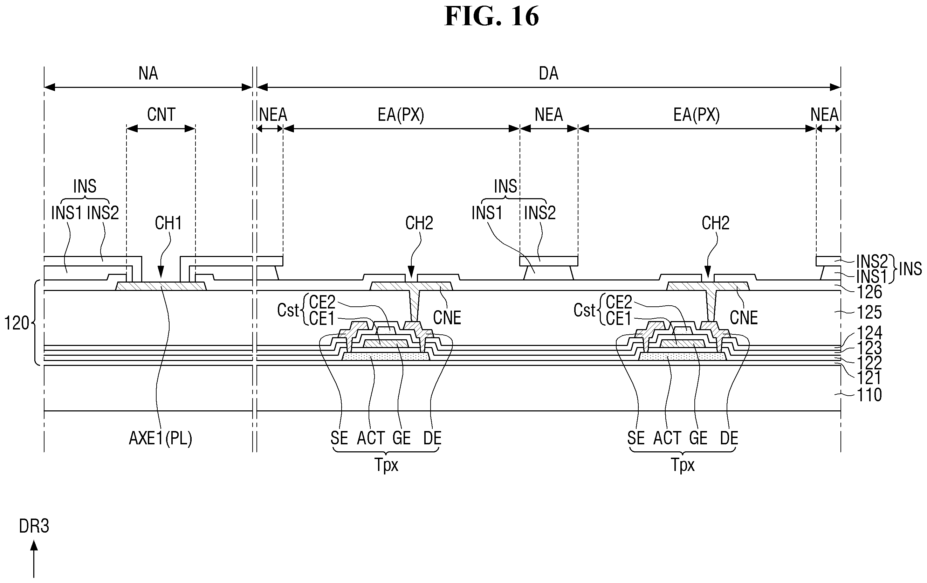

Thereafter, as illustrated in FIG. 16, the lower insulating layer INS1 is patterned by etching the lower insulating layer INS 1 using the upper insulating layer INS2 as a mask. In an embodiment, for example, the lower insulating layer INS1 may be patterned to include openings corresponding to the emission areas EA. Accordingly, the insulating layer INS may be formed in the non-emission area NEA of the display area DA and the non-display area NA. The insulating layer INS may be opened (or removed) in the area corresponding to the contact part CNT to expose a portion of the first electrode AXE1, and may be opened in areas corresponding to the emission areas EA to expose the second contact holes CH2.

In an embodiment, the lower insulating layer INS1 may be etched by an isotropic dry etching process using the upper insulating layer INS2 as a mask. In a process of etching the lower insulating layer INS1, the lower insulating layer INS1 may be etched in a form in which an upper surface thereof has a smaller area than a lower surface of the upper insulating layer INS2. Accordingly, in a subsequent process of forming the pixel electrodes ET1 and the conductive pattern CDP, the pixel electrodes ET1 and the conductive pattern CDP may be formed to be stably separated from each other simultaneously with application of a conductive material.

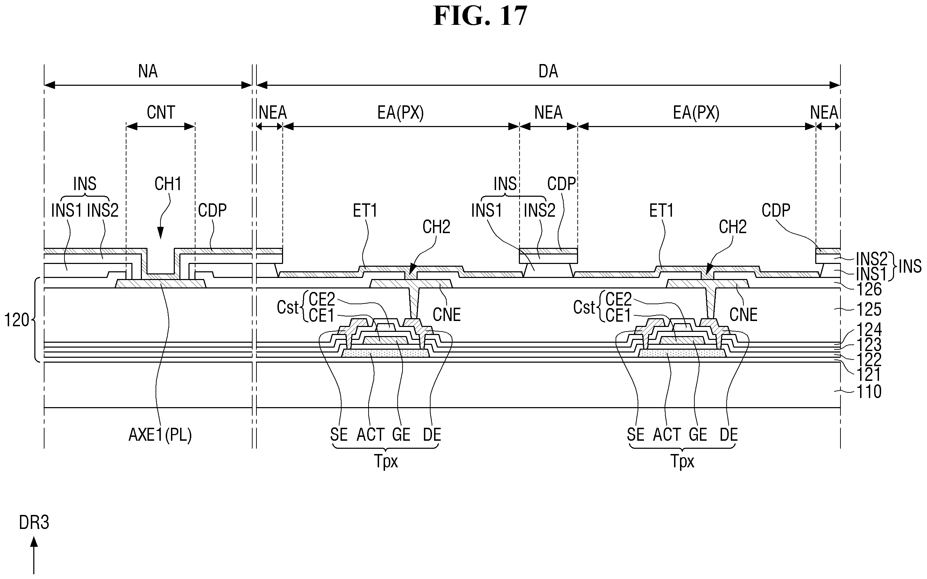

Referring to FIG. 17 in addition to FIGS. 1 to 16, the pixel electrodes ET1 and the conductive pattern CDP may be formed on the substrate 110 on which at least a double-layer insulating layer INS including the lower insulating layer INS1 and the upper insulating layer INS2, and the like, are formed. In an embodiment, for example, by entirely applying a conductive material onto the substrate 110 on which the insulating layer INS and the like are formed, the respective pixel electrodes ET1 may be formed in the emission areas EA and the conductive pattern CDP may be formed on a portion of the exposed first electrode AXE1 (or the exposed first electrode AXE1 and second electrode AXE2) and the upper insulating layer INS2. Due to the insulating layer INS, the pixel electrodes ET1 and the conductive pattern CDP may be formed to be separated (or disconnected) from each other in a process of applying the conductive material without performing a separate etching and/or patterning process. For example, by entirely applying the conductive material onto the substrate 110 on which the insulating layer INS and the like are formed, at a smaller height than the lower insulating layer INS1, the pixel electrodes ET1 and the conductive pattern CDP may be formed to be separated from each other.

In an embodiment, due to a shape of the insulating layer INS, an edge of each of the pixel electrodes ET1 adjacent to the insulating layer INS may be formed as an inclined surface whose thickness and height gradually decrease. Accordingly, even though an additional insulating pattern (e.g., a pixel defining layer) is not formed in the non-emission area NEA, it is possible to prevent dielectric breakdown from occurring between the pixel electrodes ET1 and the common electrode ET2 to be formed in a subsequent process.

The pixel electrodes ET1 may be electrically connected to the respective connection electrodes CNE and/or transistors Tpx through the respective second contact holes CH2. The conductive pattern CDP may be connected to the first electrode AXE1 through the first contact hole CH1. In an embodiment, for example, a portion of the conductive pattern CDP may be in contact with the exposed first electrode AXE1 in the contact part CNT. When the display device 100 including the second electrode AXE2 is manufactured, a portion of the conductive pattern CDP may be connected to the exposed second electrode AXE2.

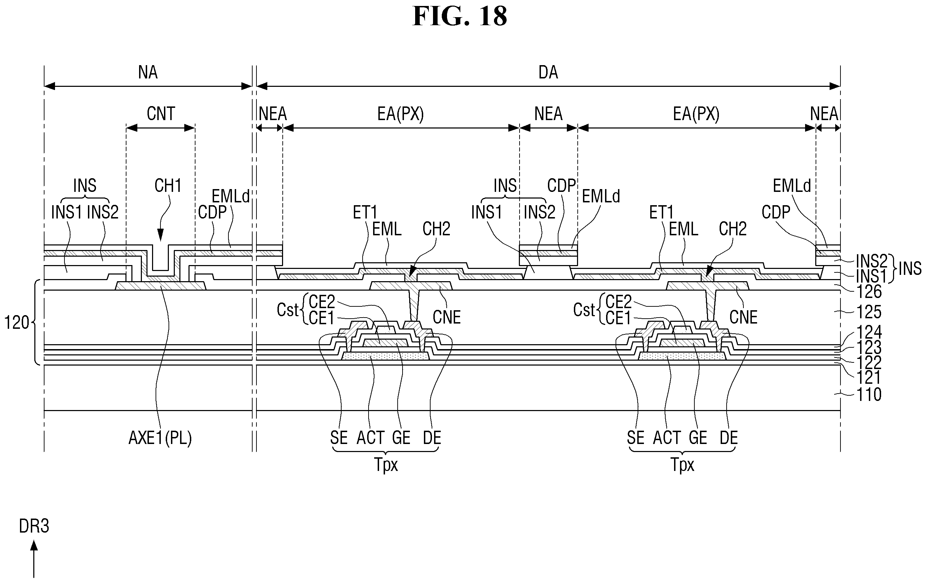

Referring to FIG. 18 in addition to FIGS. 1 to 17, the light emitting layer EML is formed on the substrate 110 on which the pixel electrodes ET1, the conductive pattern CDP, and the like, are formed. In an embodiment, when the light emitting layer EML is configured as multiple layers including at least one sub-light emitting layer and/or an intermediate layer, materials for forming respective layers of the light emitting layer EML may be sequentially deposited.

In an embodiment, the respective light emitting layers EML may be formed in the emission areas EA so as to be separated from each other by the insulating layer INS in a process of forming the light emitting layer EML. In an embodiment, for example, the respective light emitting layers EML may be formed in the emission areas EA to be separated from each other by applying a material for forming the light emitting layer EML at a height smaller than that of the lower insulating layer INS 1. In this case, the dummy light emitting layer EMLd separated from the light emitting layers EML of the pixels PX may be formed on the conductive pattern CDP. In another embodiment, the light emitting layer EML may be entirely and/or continuously formed at least in the display area DA by applying a material for forming the light emitting layer EML at a height greater than or equal to that of the lower insulating layer INS1.

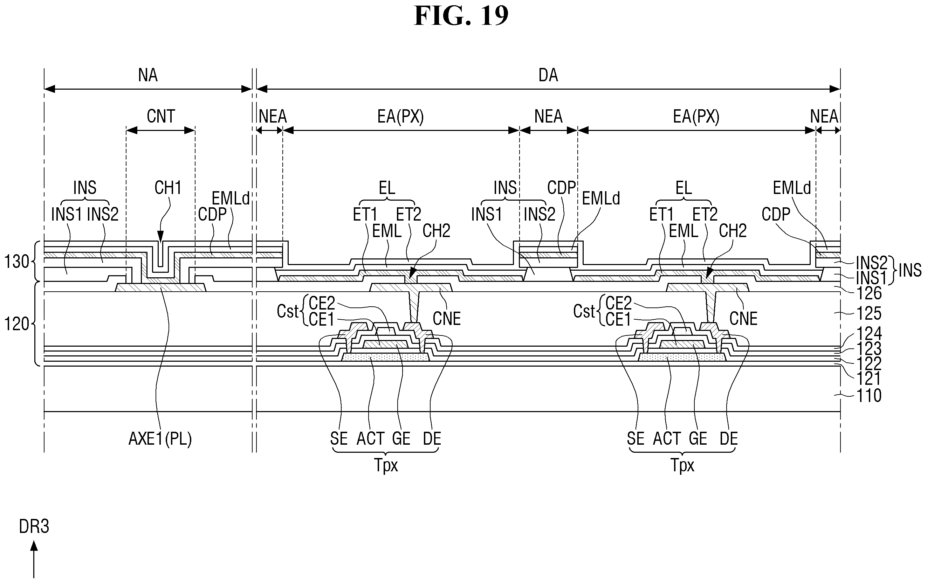

Referring to FIG. 19 in addition to FIGS. 1 to 18, the common electrode ET2 is formed on the substrate 110 on which the light emitting layers EML are formed. For example, the common electrode ET2 may be entirely and/or continuously formed at least in the display area DA by applying a conductive material for forming the common electrode ET2 at a height greater than or equal to that of the lower insulating layer INS1. Consequently, the light emitting element layer 130 may be formed.

Thereafter, the encapsulation layer 140 illustrated in FIG. 5 may be formed on the light emitting element layer 130 or the light emitting element layer 130 may be encapsulated using a separate upper substrate or the like. In addition, if desired, a process of forming or disposing color filters and/or wavelength conversion patterns on the light emitting element layer 130 or the encapsulation layer 140 may be additionally performed.

As described above, the display device 100 according to embodiments includes the insulating layer INS positioned in the non-emission area NEA between the emission areas EA of the pixels PX and the non-display area NA. The insulating layer INS may have at least a double-layer structure including the lower insulating layer INS1 positioned between the pixel electrodes ET1 disposed in the respective emission areas EA and the upper insulating layer INS2 disposed on the lower insulating layer INS1.

In addition, the display device 100 according to embodiments includes the conductive pattern CDP disposed on the insulating layer INS so as to be separated from the pixel electrodes ET1. The first voltage having a voltage level capable of blocking, preventing, or reducing the leakage current from flowing between the pixels PX may be applied to the conductive pattern CDP.

In the display device 100 and the method for manufacturing the display device 100 according to embodiments, it is possible to form the pixel electrodes ET1 so as to be automatically (or naturally) and/or immediately separated from each other by the insulating layer INS. In such embodiments, it is possible to form the conductive pattern CDP on the insulating layer INS while forming the pixel electrodes ET1 so as to be separated from each other by the insulating layer INS. Accordingly, it is possible to simplify and facilitate the manufacturing process of the display device 100 and reduce or minimize a distance between the emission areas EA of the pixels PX, if desired.

In addition, in the display device 100 and the method for manufacturing the same according to embodiments, it is possible to define the emission areas EA by the insulating layer INS without providing a separate pixel defining layer on the pixel electrodes ET1. Accordingly, it is possible to simplify the structure and the manufacturing process of the display device 100 and increase the degree of freedom in design of the display device 100.

In addition, in the display device 100 and the method for manufacturing the same according to embodiments, it is possible to block, prevent, or reduce the leakage current from flowing between the pixels PX through the non-emission area NEA. For example, it is possible to block, prevent, or reduce the leakage current between the pixels PX by the insulating layer INS. In addition, it is possible to more effectively block, prevent, or reduce the leakage current between the pixels PX by applying the first voltage to the conductive pattern CDP. For example, even in a high-resolution display device 100 in which a size of the pixels PX and a distance between the pixels PX are substantially small or reduced compared to a display device having a relatively low resolution, it is possible to effectively block, prevent, or reduce the leakage current between the pixels PX. The conductive pattern CDP may be formed simultaneously with the pixel electrodes ET1, and may effectively block, prevent, or reduce the leakage current without adding a process of forming a separate electrode or line for blocking the leakage current. Accordingly, it is possible to simplify the structure and the manufacturing process of the display device 100.

The invention should not be construed as being limited to the embodiments set forth herein. Rather, these embodiments are provided so that this disclosure will be thorough and complete and will fully convey the concept of the invention to those skilled in the art.

While the invention has been particularly shown and described with reference to embodiments thereof, it will be understood by those of ordinary skill in the art that various changes in form and details may be made therein without departing from the scope of the invention as defined by the following claims.

## Claims

1. A display device comprising:
a substrate on which a display area and a non-display area are defined;
pixels disposed on the substrate, wherein the pixels include pixel electrodes disposed respectively in emission areas positioned in the display area, light emitting layers disposed respectively on the pixel electrodes, and a common electrode disposed on the light emitting layers;
an insulating layer disposed on the substrate and positioned in a non-emission area between the emission areas of the pixels and in the non-display area; and
a conductive pattern disposed on the insulating layer to be separated from the pixel electrodes of the pixels, wherein the conductive pattern is configured to receive a first voltage,
wherein the insulating layer includes:
a lower insulating layer positioned between the pixel electrodes in the display area; and
an upper insulating layer disposed on the lower insulating layer and having a greater area than an upper surface of the lower insulating layer.

2. The display device of claim 1, wherein the conductive pattern includes a same conductive material as the pixel electrodes.

3. The display device of claim 1 or claim 2, wherein the first voltage is a turn-off voltage of a light emitting element including the pixel electrode, the light emitting layer, and the common electrode.

4. The display device of any one of claims 1 to 3, further comprising:
(i) a first electrode positioned in the non-display area, disposed between the substrate and the insulating layer, and connected to the conductive pattern through a contact hole defined through the insulating layer; and/or
(ii) a second electrode positioned in the non-emission area, disposed between the substrate and the insulating layer, and connected to the conductive pattern through a contact hole defined through the insulating layer.

5. The display device of any one of claims 1 to 4, wherein the upper insulating layer completely covers the upper surface of the lower insulating layer, and protrudes toward an adjacent one of the pixels more than the lower insulating layer does.

6. The display device of any one of claims 1 to 5, wherein
the lower insulating layer includes an organic insulating material, and
the upper insulating layer includes an inorganic insulating material.

7. The display device of any one of claims 1 to 6, wherein a thickness of the lower insulating layer is greater than a thickness of the pixel electrode.

8. The display device of claim 7, wherein the thickness of the lower insulating layer is less than or equal to a sum of thicknesses of the pixel electrode, the light emitting layer, and the common electrode, optionally wherein:
the common electrode of the pixels is a common film covering the conductive pattern, and is entirely disposed in the display area including the emission areas and the non-emission area.

9. The display device of claim 7, wherein the thickness of the lower insulating layer is greater than a sum of thicknesses of the pixel electrode and the light emitting layer, optionally wherein:
the light emitting layers of the pixels are separated from each other with the lower insulating layer interposed therebetween, and
the display device further comprises a dummy light emitting layer disposed on the conductive pattern in the non-emission area and separated from the light emitting layers of the pixels.

10. The display device of claim 7, wherein the thickness of the lower insulating layer is less than or equal to a sum of thicknesses of the pixel electrode and the light emitting layer, optionally wherein:
the light emitting layer of the pixels is a common film covering the conductive pattern, and is entirely disposed in the display area including the emission areas and the non-emission area.

11. The display device of any one of claims 1 to 10, wherein the conductive pattern has a mesh shape provided with openings corresponding to the emission areas of the pixels when viewed in a thickness direction of the substrate.

12. A method for manufacturing a display device, the method comprising:
forming transistors and connection electrodes in a display area on a substrate and forming an auxiliary electrode in a non-display area on the substrate, wherein the display area and the non-display area positioned around the display area are defined on the substrate, and the connection electrodes are connected to the transistors;
forming a lower insulating layer by applying an organic insulating material onto the substrate on which the connection electrodes and the auxiliary electrode are formed, and etching the lower insulating layer in a way such that a portion of the auxiliary electrode is exposed;
forming an upper insulating layer by applying an inorganic insulating material onto the substrate on which the lower insulating layer is formed, and etching the upper insulating layer in a way such that a portion of the auxiliary electrode in the non-display area is exposed and portions of the lower insulating layer respectively in emission areas positioned in the display area are exposed;
etching the lower insulating layer using the upper insulating layer as a mask to pattern the lower insulating layer to be provided with openings corresponding to the portion of the auxiliary electrode and the emission areas;
forming pixel electrodes respectively in the emission areas and forming a conductive pattern, which is separated from the pixel electrodes, on the exposed portion of the auxiliary electrode and the upper insulating layer, by applying a conductive material onto the substrate on which the patterned lower insulating layer and the upper insulating layer are formed;
forming a light emitting layer on the substrate on which the pixel electrodes and the conductive pattern are formed; and
forming a common electrode on the substrate on which the light emitting layer is formed.

13. The method for manufacturing a display device of claim 12, wherein in the etching of the lower insulating layer using the upper insulating layer as the mask, the lower insulating layer is etched in a way such that an upper surface thereof has a smaller area than a lower surface of the upper insulating layer.

14. The method for manufacturing a display device of claim 12 or claim 13, wherein in the forming of the respective pixel electrodes and the forming of the conductive pattern, the pixel electrodes and the conductive pattern are separated from each other by entirely applying the conductive material at a height less than a height of the lower insulating layer.

15. The method for manufacturing a display device of any one of claims 12 to 14, wherein in the forming of the common electrode, the common electrode is entirely formed in the display area by applying a conductive material for forming the common electrode at a height greater than or equal to a height of the lower insulating layer, optionally further comprising, before the forming of the lower insulating layer, forming an inorganic insulating layer by applying an inorganic insulating material onto the substrate on which the connection electrodes and the auxiliary electrode are formed and etching the inorganic insulating layer in a way such that portions of the auxiliary electrode and each of the connection electrodes are exposed.
